# EUROPEAN PATENT APPLICATION

(11) **EP 3 067 471 A1**
(43) Date of publication of application: **14.09.2016**
(21) Application number: 15305372.3
(22) Date of filing: 12.03.2015
(51) Int. Cl.: E02D 29/12, G02B 6/44, H02B 7/06, H02G 9/10, H05K 7/20

(54) **Method for modifying thermal performance and a cooling system**

(71) Applicant: ALCATEL LUCENT, 92100 Boulogne-Billancourt (FR)
(72) Inventor: Donnelly, Brian, 15 Dublin (IE); Frizzell, Ronan, 15 Dublin (IE); Howard, James, 15 Dublin (IE); Hernon, Domhnaill, 15 Dublin (IE); Maes, Jochen, 2018 Antwerp (BE)
(74) Representative: Bryers LLP

(57) **Abstract**

A method for modifying thermal performance of an electronic apparatus deployed in a subterranean region, the method including separating the region from surrounding subterranean material using a separation element, burying the apparatus in the region using doped material, the doped material comprising a first material having a first thermal conductivity doped with a second material having a second thermal conductivity, wherein a thermal conductivity of the second material is higher than the thermal conductivity of the first material to increase thermal performance of the first material.

## Description

### TECHNICAL FIELD

Aspects relate, in general, to a cooling system and a method for cooling an underground electronic apparatus.

### BACKGROUND

Future deployment of next generation telecommunications infrastructures aims to bring fibre as close to the end user as possible. Current fixed access devices are typically placed in cavities beneath ground level such as in man-holes or even smaller hand-holes before being split to multiple end users. For example, an electronic apparatus such as a router that receives a broadband signal from a fibre-based infrastructure can be used to split off a broadband signal for multiple end users over traditional cabling, such as copper cabling for example. The current method of deployment involves digging a hole and building or inserting a structure into the hole. This could be a concrete enclosure or a moulded plastic structure. Both have access through a surface opening that can be sealed closed.

Next generation deployment is anticipated to take place directly in the ground outside each and every home with a single unit serving a single home. This means that devices could be deployed to an entire housing estate without the need to enter private property. The connection to the home is made and a subscriber upgrades to the high bandwidth provided by such a device when they are ready. An example of such a technology is a telecoms node or broadband router device which can provide fibre speeds over relatively short lengths of copper wires, hence the deployment close to individual homes. In such deployment, the electronic apparatus used to provide services, such as broadband, will likely be buried beneath ground in a small hole directly in the soil.

### SUMMARY

According to an example, there is provided a method for modifying thermal performance of an electronic apparatus deployed in a subterranean region, the method including separating the region from surrounding subterranean material using a separation element, burying the apparatus in the region using doped material, the doped material comprising a first material having a first thermal conductivity doped with a second material having a second thermal conductivity, wherein a thermal conductivity of the second material is higher than the thermal conductivity of the first material to increase thermal performance of the first material. The doped material can be soil or sand and the separation element can be a lining, mesh or lattice. The method can include covering the apparatus in a thermally conductive matrix having a thermal conductivity which is higher than the thermal conductivity of the first material. The method can further include compressing the apparatus in the region, whereby to encase the apparatus in the thermally conductive matrix. The region can be covered with an insulated thermal barrier. The method can include deploying or installing an impermeable membrane at the base of the region to sit beneath the apparatus, whereby to collect or otherwise trap water.

According to an example, there is provided a cooling system for a subterranean electronic apparatus, the system comprising a doped material, the doped material comprising a first material having a first thermal conductivity doped with a second material having a second thermal conductivity, wherein a thermal conductivity of the second material is higher than the thermal conductivity of the first material to increase thermal performance of the first material, the doped material being configured to receive the apparatus in a subterranean region separated from surrounding subterranean material using a separation element. The doped material can be soil or sand and the separation element can be a lining, mesh or lattice. The second material can include strands or pieces of metal and/or encapsulated phase change material. A a thermally conductive matrix can be configured to cover the apparatus, the thermally conductive matrix having a thermal conductivity which is higher than the thermal conductivity of the first material. The thermally conductive matrix can be a metal foam. The thermally conductive matrix can be compressed around the apparatus to encase the apparatus. The region can be covered with an insulated thermal barrier. An impermeable membrane can be deployed or installed at the base of the region to sit beneath the apparatus, to collect or otherwise trap water. A support can be provided at the base of the region to support the apparatus within the region.

### BRIEF DESCRIPTION OF THE DRAWINGS

Embodiments will now be described, by way of example only, with reference to the accompanying drawings, in which:
Figure 1 is a schematic representation of a cooling system according to an example;
Figure 2 is a schematic representation of a cooling system according to an example;
Figures 3a and 3b are schematic representations of a cooling system according to an example; and
Figures 4a-c are schematic representations of linings for a cooling system according to an example.

### DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Deployment of electronic apparatus used to provide services, such as broadband, directly in the soil beneath ground differs greatly from the current use of man/hand holes as there is no longer air surrounding the product. The lack of air makes heat dissipation from the product extremely challenging.

Thermal management solutions for existing devices allow for the thermal load from an electronic apparatus to be dissipated into convecting air, however, this is not possible with the proposed subterranean method of deployment. This means the only mode of heat transport is conduction through the soil, which is problematic since soil has a poor thermal conductivity, and hence, poor heat removal capability.

According to an example, there is provided a method and system of increasing the thermal conductivity of the material surrounding an electronic apparatus deployed in the ground. This enables the product to be deployed underground without overheating. The enhanced conductivity of the material effectively increases the available surface area over which the product can dissipate heat, which greatly enhances its thermal performance. Moreover, materials, such as soil types, vary considerably depending on the location, altitude and climate. This means that simply placing the product in the existing soil is not appropriate given the extent of variation. In an example, soil or other material within which an electronic apparatus is to be buried for deployment directly in the ground, is doped with an additive to increase the thermal performance thereof. This can increase the thermal conductivity and/or thermal storage of the material to enhance its heat removal capability.

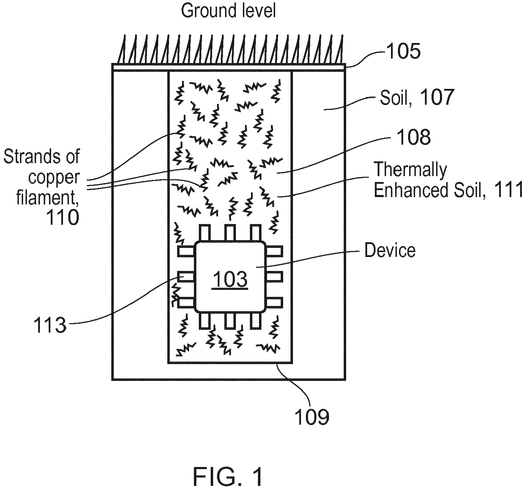

Figure 1 is a schematic representation of a cooling system according to an example. A subterranean electronic apparatus 103 is deployed below ground level 105. A hole is dug into the soil 107, or other subterranean material, which may include sand, clay, hardcore, cement, aggregate and the like or any combination thereof, such as a mixture of sand and soil for example to provide a subterranean region, generally depicted in lighter shade, which, in an example, is separated from surrounding subterranean material, generally depicted in darker shade, using a separation element 109. That is, an element is provided in a hole that has been excavated or dug out from the ground in order to separate material placed into (or to be placed into) the hole from surrounding material. The separation element 109 is provided against the walls and floor of the hole, and may be fixed in place using fixings such as rivets, screws, nails, dowels or adhesive and so on. In some examples, the separation element 109 is resilient or semi-rigid and may therefore be maintained in a desired position without the use of any additional fixings.

In an example, a separation element is a lining, mesh or lattice 109, which can be thermally conductive, such as a lining, mesh or lattice and so on made from encapsulated metal (encapsulated to protect the metal from moisture in the ground). The region can be dug out of the ground to a desired depth and width and so on, and the mesh 109 can be introduced into the hold to cover the bottom and/or sides of the hole, but leaving the opening at the top exposed to enable apparatus 103 and doped material 111 to be introduced into the lined hole forming the region.

According to an example, the apparatus 103 is buried in the hole using doped material 111. In an example, the doped material comprises a first material having a first thermal conductivity doped with a second material having a second thermal conductivity. A thermal conductivity of the second material is higher than the thermal conductivity of the first material to increase thermal performance of the first material. The doped material, that is the first material can be, for example soil or sand. The second material can be selected from one or more suitable materials as will be described below.

The lining, mesh or lattice can act to reduce the tendency of the doped material 111 to dissipate over time, which may be exacerbated by ingress and egress of animals that may happen to live or pass through the region in question. That is, the thermally enhanced material 111 can be supported and maintained in position in the region using a mesh or lattice 109, or any other suitable structure or material such as webbing or netting, or a framework. Gaps provided in the mesh or lattice and so on can be selected in size and position in order to counteract the effects of animals which may otherwise try to pass into the enhanced region 111. For example, a lattice or mesh can be provided with interstices, gaps or openings that are selected to be relatively small, such as of the order of 1-2mm so as to prevent ingress of animals but allow moisture to penetrate and/or escape. In an example, a fabric or permeable material can be used to line the hole within which the apparatus is to be deployed. For example, a nylon weaved fabric or material may be used. In an example, the lining is relatively thin, such as of the order of several millimetres for example. As such, it presents a minimal resistance to heat transfer.

In an example, the doped material 111, such as doped soil, is doped with a thermally conductive or absorbent additive such as strands or pieces of metal, such as copper filaments for example. Once deployed, the apparatus 103 is covered with the material 111 in order to improve transfer of heat from the product to the surrounding non-enhanced material/soil 107. In the example if figure 1, the thermally enhanced soil has been doped with long strands of copper filament, although any higher thermal conductivity material can be used. In an example, the filaments or pieces can be coated in a material to protect it from the elements. That is, the first material 108 can be soil and/or sand and so on, and the second material 110 can be strands or pieces of metal. The mixture of the first 108 and second 110 materials makes up the thermally enhanced material 111.

Accordingly, the addition of long strands of high thermal conductivity material to a bulk medium such as sand will increase the effective conductivity of the two together. This will keep costs low and allow a large volume of the material to be deployed.

For example, for a small product volume, say 50mm cubed, a hole measuring 150mm in diameter and 500 mm deep could be dug and lined or otherwise provided with a thermally conductive mesh or lattice for the base and/or side(s) of the hole. Prepared material, such as soil, containing the additive would be poured in up to the level of about 100mm, then the product is placed on the soil and power/communication cables connected. The remainder of the hole is then covered with soil and additive and sealed at the surface. Optionally a removable access can be placed at the surface 105 for maintenance.

The underground deployment is currently aimed at small products measuring approximately 50mm cubed. These products have small surface area for heat transfer, even with fins 113 added to the surface. By placing the product in a soil containing an additive, heat can relatively easily be conducted into the larger volume of enhanced soil (in the example above this is a cylinder measuring 150mm in diameter, 500 mm high), thus, the effective heat transfer surface area for conduction into the normal soil is greatly increased, without affecting product volume and market acceptability.

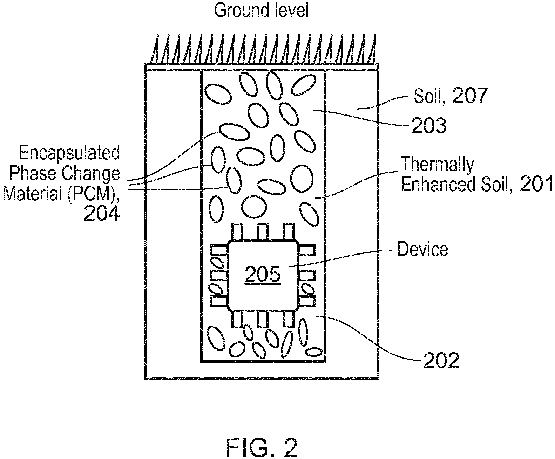

Figure 2 is a schematic representation of a cooling system according to an example. In the example of figure 2, material 201 in the region (hole) 203 includes a dopant or doping agent in the form of encapsulated Phase Change Materials (PCMs) that have been added to the bulk medium 202 used to bury the apparatus 205. The first material 202 can be soil and/or sand and so on, and the second material 204 can be encapsulated PCM. The mixture of the first 202 and second 204 materials makes up the thermally enhanced material 201.

PCMs can absorb large amounts of heat without changing temperature through latent heat of fusion. Heat generated by the device 205 during peak times will be adequately transferred to the surrounding bulk material with PCM additives. During off peak times, this heat can be released to the surrounding soil. Some examples of suitable PCMs are paraffin and salt hydrates, which may be encapsulated in a polymer such as Polyolefin or Polypropylene.

Similarly to the system of figure 1, the region in which the thermally enhanced material 201 is provided can be lined or otherwise provided with a separation element that can be in the form of a mesh or lattice and so on to mitigate or prevent migration or dissipation of the material 201 into the surrounding material 207.

An encapsulated PCM will always absorb heat if its temeprature is below that of the surrounding (as will any and all materials), and vice versa. However, when it reaches its phase change temperature (determined by the material/physical properties, water is at 0 or 100 degrees Celsius for example), it will remain at a constant temperature until it changes phase. It is typically well known that different PCMs exhibit different absorption characteristics, such as rate of absorption and temperature at which absorption is triggered. For example, for apparatus that may fail if its temperature exceeds 70°C, material 111, 201 can be doped with encapsulated PCMs that are selected to begin absorbing heat at 50°C. Thus, the apparatus can be protected from overheat, and the tuning can provide a time delay characteristic to enable heat absorption to occur only when required.

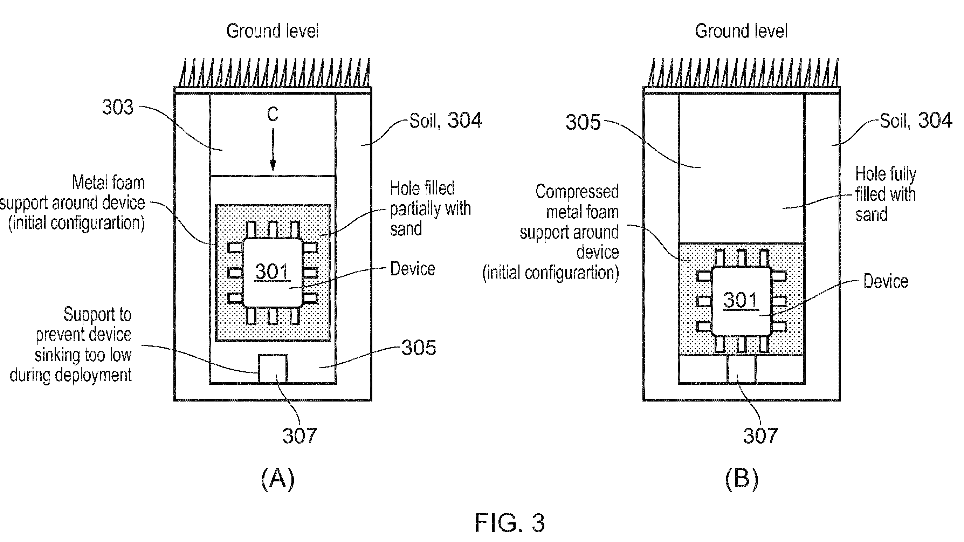

Figures 3a and 3b are schematic representations of a cooling system according to an example. In the example of figures 3a, 3b, apparatus 301 is embedded into a three-dimensional metal mesh or metal foam, typically made from a high conductivity material (examples are aluminium and copper) forming a thermally conductive matrix, and placed in the hole 303 dug out from material 304, such as soil and so on. Material, such as sand or soil for example is then poured over the encased product/metal mesh assembly so that the material permeates the cavities of the metal mesh/foam (wet sand could be used in this scenario for example) but the hole 303 is not fully filled. A separation element may or may not be used in hole 303.

A compressive force, C, is then applied onto the top of the metal mesh covered in material that is capable of compressing the metal mesh/foam, which has the effect of enhancing the number of thermal paths from the device to the surrounding soil, giving a thermally enhanced medium next to the device. Apparatus 301 which is encased in thermally conductive matrix which has been compressed around the apparatus is depicted in figure 3b. The remainder of the hole 303 can be filled with material to the ground level. In the example of figures 3a, 3b, the material 305 may or may not be doped.

A solid support 307 can be provided under the assembly to ensure the product 301 does not sink too far during deployment. This can be a block of wood, concrete or metal and so on, and may extend over substantially the whole of the floor of the hole 303, or which may only be provided under a portion of the apparatus 301 for example. In the former case, the support may also act as an impermeable cover for the floor of the hole 303 for reasons discussed below (in place of or in addition to another impermeable cover).

The compressive force, C, applied to the apparatus 301 covered in the thermally conductive matrix results in the mesh tightly adhering to the product and also extending to the sides of the hole 303 creating the scenario shown in figure 3b, in which the heat removal capability of the soil surrounding the product is enhanced. As noted before, all examples described above could be used as standalone solutions or combined together for even more improvement.

Depending on local ambient conditions, a hole cover could be employed that acts as a thermal shield for the buried equipment (not illustrated in the figures). This can be located at the surface above the product allowing access to the device for maintenance. It can be adapted to both reflect an incoming solar load back away from the surface and provide an insulated thermal barrier to heat transfer from the ambient air into the soil. In an example, this can be achieved by coating the upper surface with light reflecting materials and by thermally insulating the hole cover.

The above mentioned embodiments could also benefit from a method of trapping moisture around the product such as rainwater. This can take the form of an impermeable membrane that is fitted, placed or deployed into the bottom of the hole that the product sits within. During periods of wet weather, the membrane traps water around the product which aids in heat transfer from the product to the soil (the thermal 'conductivity' of the soil increases with moisture increase).

In an example, various combinations of the system described above can be implemented. For example, a material can be doped with both encapsulated PCMs as well as a thermally conductive material such as described with reference to figure 1. It is also possible to use a system as described in figures 3a, 3b with a doped material as described with reference to figure 1 and/or 2.

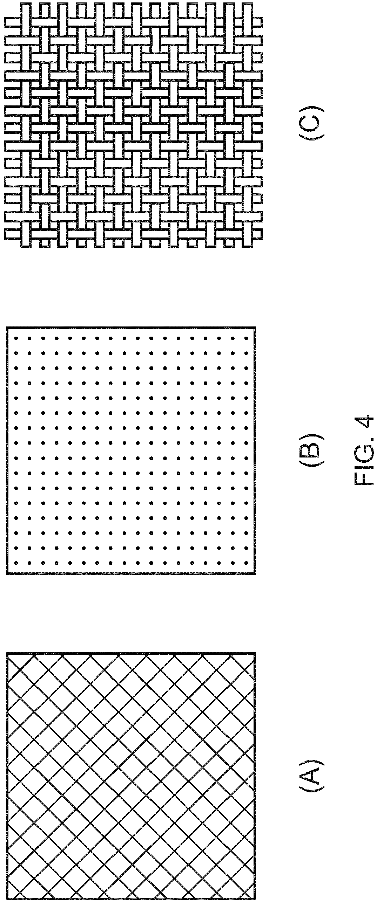

Figures 4a-c are schematic representations of separation elements or linings for a cooling system according to an example. In figure 4a, a mesh is provided in the form of an encapsulated metallic structure, similar to, for example, metal fencing. The orientation and size of the openings may be selected for the environment in which the mesh is to be deployed. For example, if the mesh is to be used only to prevent bulk movement of doped material, it may be that the openings are of the order of several centimetres in diameter. On the other hand, if the mesh is to be used to prevent subterranean animals from passing or burrowing through into the doped region, the openings may be made an order of magnitude smaller for example. Other alternatives are possible as will be appreciated by those skilled in the art.

In figure 4b, a lining is provided in the form of a laminar element with holes in. As noted with reference to figure 4a, the size and positioning of the holes can be selected as desired. In figure 4c, a lining is provided in the form a weaved material made from, for example, nylon. The gaps between the warp and weft of the material can enable ingress or egress of moisture but prevent migration of doped material and ingress of animals and so on. In all cases depicted, and noted above, the lining can be flexible in order to enable it to be placed into a hole into which apparatus is to be deployed, and cut to size.

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope.

## Claims

1. A method for modifying thermal performance of an electronic apparatus deployed in a subterranean region, the method including:
separating the region from surrounding subterranean material using a separation element;
burying the apparatus in the region using doped material, the doped material comprising a first material having a first thermal conductivity doped with a second material having a second thermal conductivity, wherein a thermal conductivity of the second material is higher than the thermal conductivity of the first material to increase thermal performance of the first material.

2. A method as claimed in claim 1, wherein the doped material is soil or sand and the separation element is lining, mesh or lattice.

3. A method as claimed in claim 1 or 2, further including covering the apparatus in a thermally conductive matrix having a thermal conductivity which is higher than the thermal conductivity of the first material.

4. A method as claimed in claim 3, further including compressing the apparatus in the region, whereby to encase the apparatus in the thermally conductive matrix.

5. A method as claimed in any preceding claim, further including covering the region with an insulated thermal barrier.

6. A method as claimed in any preceding claim, further including deploying or installing an impermeable membrane at the base of the region to sit beneath the apparatus, whereby to collect or otherwise trap water.

7. A cooling system for a subterranean electronic apparatus, the system comprising:
a doped material, the doped material comprising a first material having a first thermal conductivity doped with a second material having a second thermal conductivity, wherein a thermal conductivity of the second material is higher than the thermal conductivity of the first material to increase thermal performance of the first material;
the doped material being configured to receive the apparatus in a subterranean region separated from surrounding subterranean material using a separation element.

8. A cooling system as claimed in claim 7, wherein the doped material is soil or sand and the separation element is lining, mesh or lattice.

9. A cooling system as claimed in claim 8, wherein the second material includes strands or pieces of metal and/or encapsulated phase change material.

10. A cooling system as claimed in any of claims 7 to 9, further comprising a a thermally conductive matrix configured to cover the apparatus, the thermally conductive matrix having a thermal conductivity which is higher than the thermal conductivity of the first material.

11. A cooling system as claimed in claim 10, wherein the thermally conductive matrix is a metal foam.

12. A cooling system as claimed in claim 10 or 11, wherein the thermally conductive matrix is compressed around the apparatus to encase the apparatus.

13. A cooling system as claimed in any of claims 7 to 12, wherein the region is covered with an insulated thermal barrier.

14. A cooling system as claimed in any of claims 7 to 13, further including an impermeable membrane deployed or installed at the base of the region to sit beneath the apparatus, to collect or otherwise trap water.

15. A cooling system as claimed in any of claims 7 to 14, further including a support at the base of the region to support the apparatus within the region.
